# EUROPEAN PATENT APPLICATION

(11) **EP 4 727 298 A1**
(43) Date of publication of application: **15.04.2026**
(21) Application number: 24928238.5
(22) Date of filing: 25.12.2024
(51) Int. Cl.: H10F 19/80

(54) **ZERO-BUSBAR PHOTOVOLTAIC CELL STRING SOLDERING METHOD AND ZERO-BUSBAR PHOTOVOLTAIC CELL STRING SOLDERING APPARATUS**

(30) Priority: 04.03.2024 CN 202410239688; 26.06.2024 CN 202410840624
(71) Applicant: CHINT New Energy Technology Co., Ltd., Jiaxing, Zhejiang 314400 (CN)
(72) Inventor: HU, Zhaogang, Jiaxing, Zhejiang 314400 (CN); HE, Chenxu, Jiaxing, Zhejiang 314400 (CN); CHEN, Junjie, Jiaxing, Zhejiang 314400 (CN); JIN, Yeyi, Jiaxing, Zhejiang 314400 (CN); HSU, Wei-Chih, Jiaxing, Zhejiang 314400 (CN)
(74) Representative: PGA S.p.A., Milano, Succursale di Lugano
(86) International application number: PCT/CN2024/142139
(87) International publication number: WO 2025/185309

(57) **Abstract**

A zero-busbar photovoltaic cell string soldering method and a zero-busbar photovoltaic cell string soldering apparatus. The method comprises: conveying zero-busbar photovoltaic cells and solder strips to a pre-soldering device, and performing heating so that each solder strip is pre-fixed on the surface of the corresponding zero-busbar photovoltaic cell, so as to obtain a cell string column; and conveying the cell string column to a position below a heating and pressurizing device, controlling the heating and pressurizing device to move to be in contact with a front film layer on the cell string column, and heating and pressurizing the front film layer to obtain a cell string. The cells and the solder strips are pre-fixed, then film laminating is performed, and the front film layer is heated and pressurized. During heating and pressurizing, it is not needed to place a pressing tool on a front surface, thereby avoiding uneven heating, avoiding the problems of bubbling of a film layer and a cold solder joint, ensuring the soldering quality, reducing the cold solder joint and grid breaking. When pre-soldering is finished, heating and pressurizing are carried out, thereby preventing the solder strip from deviating.

## Description

The present application claims priorities to Chinese Patent Application No. 202410840624.8, titled "ZERO-BUSBAR PHOTOVOLTAIC CELL STRING SOLDERING METHOD AND ZERO-BUSBAR PHOTOVOLTAIC CELL STRING SOLDERING APPARATUS", filed on June 26, 2024 with the China National Intellectual Property Administration; and Chinese Patent Application No. 202410239688.2, titled "PHOTOVOLTAIC CELL STRING SOLDERING APPARATUS AND PHOTOVOLTAIC CELL STRING SOLDERING METHOD", filed on March 04, 2024 with the China National Intellectual Property Administration, both of which are incorporated herein by reference in their entireties.

### FIELD

The present application relates to the field of photovoltaic cell production, and in particular to a zero-busbar photovoltaic cell string soldering method and a zero-busbar photovoltaic cell string soldering apparatus.

### BACKGROUND

The process for stringing zero-busbar photovoltaic cells into a cell string generally includes applying a back film layer, arranging back solder strips, placing a zero-busbar photovoltaic cell, arranging front solder strips, applying a front film layer, and positioning a pressing tool. The front film layer is heated by an infrared lamp, involving outward-to-inward heat transfer. Since the pressing tool is required on the front side to fix the front film layer and the solder strips, and heating by the infrared lamp is a form of radiation, the pressing tool may cause uneven heating temperatures across the surface of the zero-busbar photovoltaic cell, thereby leading to issues such as bubbling of the film layer and poor soldering between a finger and the solder strip.

In addition, the above-mentioned front film layer and back film layer are applied for a single zero-busbar photovoltaic cell. Pre-crosslinking may occur within the film layers during the heating process, so that the front film layer is adhered to the pressing tool and the back film layer is adhered to a belt, thereby increasing the risk of abnormalities such as solder strip shifting and poor soldering.

Therefore, how to address the above technical issues should be a key focus for those skilled in the art.

### SUMMARY

An object of the present application is to provide a zero-busbar photovoltaic cell string soldering method and a zero-busbar photovoltaic cell string soldering apparatus to avoid issues occurring within the cell string such as poor soldering, finger breakage, and bubbling of the front film layer.

To address the above technical issues, a zero-busbar photovoltaic cell string soldering method is provided according to the present application, including the following steps:
conveying zero-busbar photovoltaic cells and solder strips to a pre-soldering device, and performing heating to pre-fix each solder strip onto a surface of the corresponding zero-busbar photovoltaic cell, so as to obtain a cell string column; and
conveying the cell string column to a position below a heating and pressurizing device, controlling the heating and pressurizing device to move until it comes into contact with a front film layer on the cell string column and to heat and pressurize the front film layer, so as to obtain a cell string.

Optionally, pre-fixing each solder strip onto the surface of the corresponding zero-busbar photovoltaic cell includes:
conveying the zero-busbar photovoltaic cell to a position below a heating device, and placing a pre-fixing adhesive film on a front side of the zero-busbar photovoltaic cell, such that the pre-fixing adhesive film, under the action of the heating device, pre-fixes the solder strip onto a front surface of the cell, and the pre-fixing adhesive film forms the front film layer on the cell string column.

Heating and pressurizing the front film layer includes: smoothing out the pre-fixing adhesive film.

Optionally, the cell string column and a back film layer are synchronously conveyed to the heating and pressurizing device, and the front film layer is applied on the cell string column.

Optionally, controlling the heating and pressurizing device to heat and pressurize the front film layer includes:
controlling the heating and pressurizing device to simultaneously heat and pressurize at least two adjacent zero-busbar photovoltaic cells in the cell string column.

Optionally, there are at least two front film layers applied on the cell string column.

Optionally, synchronously conveying the cell string column and the back film layer to the heating and pressurizing device includes:
synchronously conveying the cell string column and a single back film layer to the heating and pressurizing device, such that the back film layer covers all the zero-busbar photovoltaic cells in the cell string column and is arranged in an elongated strip along an extension direction of the cell string column.

Optionally, synchronously conveying the cell string column and the back film layer to the heating and pressurizing device includes:
conveying the cell string column and at least two back film layers to the heating and pressurizing device, such that each back film layer covers at least two zero-busbar photovoltaic cells in the cell string column and is arranged in an elongated strip along the extension direction of the cell string column. The at least two back film layers are conveyed in sequence. The conveying of the cell string column starts upon initiation of the conveying of a first back film layer, and ends when the conveying of a last back film layer is finished.

Optionally, before synchronously conveying the cell string column and the back film layer to the heating and pressurizing device, the zero-busbar photovoltaic cell string soldering method further includes:
controlling a string-cutting device to cut the solder strip on the cell string column to obtain a cell string column of a target length.

Optionally, the zero-busbar photovoltaic cell string soldering method further includes: providing the zero-busbar photovoltaic cells each having fingers, some of which have a larger width than the other fingers.

Performing heating to pre-fix each solder strip onto the surface of the corresponding zero-busbar photovoltaic cell includes:
under the action of the pre-soldering device, causing metallic melting of the solder strip at contact points with the fingers with the larger width on the zero-busbar photovoltaic cell, to pre-fix the solder strip onto the zero-busbar photovoltaic cell.

Optionally, the zero-busbar photovoltaic cell string soldering method further includes:
widening fingers located at edges of both ends of the zero-busbar photovoltaic cell in the extension direction of the cell string column, such that at least two fingers with the larger width are provided at each edge of the zero-busbar photovoltaic cell.

A zero-busbar photovoltaic cell string soldering apparatus is provided according to the present application, including a pre-soldering device, a heating and pressurizing device and a conveying device.

In a transport direction of a cell string, the pre-soldering device is located upstream of the heating and pressurizing device, and the conveying device is located downstream of the pre-soldering device.

The pre-soldering device is configured to pre-fix each solder strip onto a surface of a corresponding zero-busbar photovoltaic cell to obtain a cell string column.

The heating and pressurizing device is configured to heat and pressurize a front film layer on the cell string column.

Optionally, the conveying device is configured to synchronously convey a back film layer and the cell string column to the heating and pressurizing device.

Optionally, the zero-busbar photovoltaic cell string soldering apparatus further includes a pressing-tool picking device.

The pressing-tool picking device is configured to remove a pressing tool located on the cell string column after pre-soldering.

The pressing-tool picking device is located between the pre-soldering device and the heating and pressurizing device in the transport direction of the cell string.

A zero-busbar photovoltaic cell string soldering method according to the present application, including the following steps: conveying zero-busbar photovoltaic cells and solder strips to a pre-soldering device, and performing heating to pre-fix each solder strip onto a surface of the corresponding zero-busbar photovoltaic cell, so as to obtain a cell string column; and conveying the cell string column to a position below a heating and pressurizing device, controlling the heating and pressurizing device to move until it comes into contact with a front film layer on the cell string column and to heat and pressurize the front film layer, so as to obtain a cell string.

It can be seen that in the zero-busbar photovoltaic cell string soldering method, the solder strip is pre-fixed to the zero-busbar photovoltaic cell, and then the cell string column formed by pre-fixing is applied with a front film and a back film. Subsequently, the front film layer is heated and pressurized to obtain a cell string. Since the pre-fixing has been carried out before the front film layer is heated and pressurized, there is no need to place a pressing tool on the front side during heating and pressurization. This avoids the phenomenon of uneven heating, thereby preventing issues such as bubbling of the film layer and poor soldering. Meanwhile, heating and pressurization may ensure the quality of soldering between the solder strip and the zero-busbar photovoltaic cell, reducing the occurrence of poor soldering and finger breakage. Moreover, by applying pressure on the front side, the front film layer may be prevented from bubbling. In addition, after pre-soldering, the front film layer is heated and pressurized by the heating and pressurizing device, which may prevent the solder strip from shifting.

In addition, a zero-busbar photovoltaic cell string soldering apparatus is further provided according to the present application, having the above advantages.

### BRIEF DESCRIPTION OF THE DRAWINGS

In order to clearly illustrate the technical solutions in embodiments of the present application or in the conventional technology, a brief illustration will be given to the accompanying drawings required for the description of the embodiments or the conventional technology. Obviously, those accompanying drawings described below are only some embodiments of the present application. For those skilled in the art, other accompanying drawings can be obtained based on these accompanying drawings without creative effort.
FIG. 1 is a first flow chart showing a zero-busbar photovoltaic cell string soldering method according to an embodiment of the present application;
FIG. 2 is a second flow chart showing a zero-busbar photovoltaic cell string soldering method according to an embodiment of the present application;
FIG. 3 is a schematic structural view of a zero-busbar photovoltaic cell string soldering apparatus according to an embodiment of the present application;
FIG. 4 is a partial schematic structural view of a zero-busbar photovoltaic cell string soldering apparatus according to an embodiment of the present application;
FIG. 5 is a schematic view showing the connection between a solder strip and a cell in a cell string according to an embodiment of the present application;
FIG. 6 is a schematic structural view of a cell string according to an embodiment of the present application;
FIG. 7 is a schematic structural view of a heating and pressurizing device according to an embodiment of the present application;
FIG. 8 and FIG. 9 are schematic views showing different quantities of film layers applied on a cell string according to an embodiment of the present application;
FIG. 10 is a schematic structural view of a photovoltaic cell string soldering apparatus according to an embodiment of the present application;
FIG. 11 is a schematic structural view of a cell string according to an embodiment of the present application; and
FIG. 12 is a flow chart showing a string soldering process performed by the photovoltaic cell string soldering apparatus according to an embodiment of the present application.

**Numeral references in the figures are listed below:**

| | | | |
|---|---|---|---|
| 1. | heating and pressurizing device; | 2. | cell string; |
| 3. | heating part; | 4. | first conveyor belt; |
| 5. | support rod; | 6. | pressing tool; |
| 7. | pressing-tool picking device; | 8. | zero-busbar photovoltaic cell; |
| 81. | finger; | 82. | widened finger; |
| 9. | solder strip; | 10. | first heating baseplate; |
| 11. | string-cutting device; | 12. | second conveyor belt; |
| 13. | vacuum suction hole; | 14. | back film layer; |
| 15. | front film layer; | 16. | second heating baseplate; |
| 17. | driving component; | 18. | elastomer; |
| 19. | box; | 20. | heating body; |
| 21. | gas inlet; | 22. | lifting lead screw; |
| 23. | bracket; | 24. | cell string column; |
| 25. | heating device; | 26. | conveyor belt; |
| 27. | heating baseplate; | 28. | first carrier film; |
| 29. | low-temperature solder strip; | 30. | cell; |
| 31. | second carrier film. | | |

### DETAILED DESCRIPTION OF THE EMBODIMENTS

The present application is described in detail in conjunction with the accompanying drawings and the embodiments herein, so as to facilitate those skilled in the art to better understand the solutions according to the present application. Obviously, the described embodiments are only some rather than all of the embodiments of the present application. Based on the embodiments of the present application, all other embodiments obtained by those ordinary skilled in the art without any creative effort should fall within the protection scope of the present application.

Various details are illustrated in the following description to facilitate thorough understanding of the present application. The present application may be implemented in a manner other than those described herein. Those skilled in the art may make similar modifications without departing from the concept of the present application. Hence, the present application is not limited to the embodiments disclosed herein.

As mentioned in the background, the current string soldering process generally involves applying a back film layer, arranging back solder strips, placing a zero-busbar photovoltaic cell, arranging front solder strips, applying a front film layer, and positioning a pressing tool. The pressing tool is required for fixing on the front side. However, infrared light may be reflected by the pressing tool, resulting in uneven heating, which in turn causes issues such as poor soldering, finger breakage, and bubbling of the film layer.

In view of this, a zero-busbar photovoltaic cell string soldering method is provided according to the present application, which may include the following steps:
conveying zero-busbar photovoltaic cells and solder strips to a pre-soldering device, and performing heating to pre-fix each solder strip onto a surface of the corresponding zero-busbar photovoltaic cell to obtain a cell string column; and
conveying the cell string column to a position below a heating and pressurizing device, controlling the heating and pressurizing device to move until it comes into contact with a front film layer on the cell string column and to heat and pressurize the front film layer to obtain a cell string.

Based on the above embodiment, in one embodiment of the present application, pre-fixing each solder strip onto the surface of the corresponding zero-busbar photovoltaic cell includes: conveying the zero-busbar photovoltaic cell to the position below a heating device, and placing a pre-fixing adhesive film on a front side of the zero-busbar photovoltaic cell, such that the pre-fixing adhesive film, under the action of the heating device, pre-fixes the solder strip onto the front surface of the cell, and the pre-fixing adhesive film forms the front film layer on the cell string column.

There is no doubt that by heating the pre-fixing adhesive film, the solder strip is pre-fixed onto the front surface of the cell, and the above-mentioned cell refers to a zero-busbar photovoltaic cell.

Heating and pressurizing the front film layer includes: smoothing out the pre-fixing adhesive film.

Specifically, in this embodiment, the string soldering method includes:
conveying the cell to the position below the heating device, with the solder strip and the pre-fixing adhesive film placed on the front side of the cell, such that the pre-fixing adhesive film, under the action of the heating device, pre-fixes the solder strip onto the front surface of the cell; and
conveying the cell passing through the heating device to a position below the heating and pressurizing device, and moving the heating and pressurizing device downward such that a elastomer located inside the heating and pressurizing device comes into contact with the pre-fixing adhesive film on the front side of the cell to smooth out the pre-fixing adhesive film.

When the cell is located below the heating device, there is a pressing tool on the surface of the cell. However, areas not covered by the pressing tool and edges of the pre-fixing adhesive film may suffer from issues such as poor pre-fixation, shrinkage and wrinkles. As the cell continues to pass through the heating and pressurizing device, the pre-fixing adhesive film is directly smoothed out, thereby minimizing potential abnormalities that could occur during subsequent transport, layout and lamination processes of the cell.

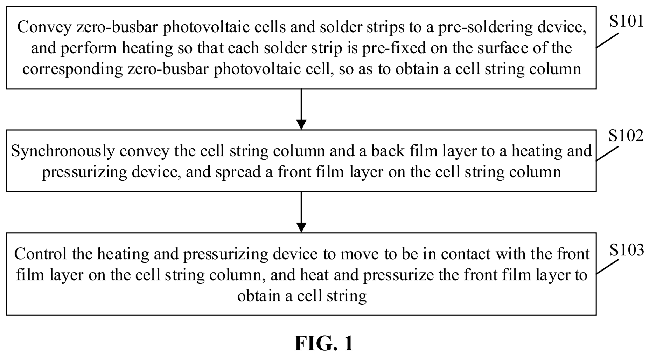

Based on the above embodiment, in another embodiment of the present application, referring to FIG. 1, the zero-busbar photovoltaic cell string soldering method may include a step S101, a step S102 and a step S103.

In the step S101, zero-busbar photovoltaic cells and solder strips are conveyed to a pre-soldering device, and heating is performed to pre-fix each solder strip onto a surface of the corresponding zero-busbar photovoltaic cell, so as to obtain a cell string column.

In this embodiment, the solder strip may be a low-temperature solder strip, which may be made of a copper-based tin-bismuth-lead material with a bismuth content of 14% to 26%.

The solder strip is pre-fixed to fingers on the zero-busbar photovoltaic cell.

It should be noted that in this embodiment, there is no limitation on the position where the solder strip is pre-fixed onto the zero-busbar photovoltaic cell. For example, the solder strip may be pre-fixed at edges of the zero-busbar photovoltaic cell, or in a middle area between the edges.

The number of zero-busbar photovoltaic cells in a cell string column may be determined as needed and is not limited in this embodiment.

In the step S102, the cell string column and a back film layer are synchronously conveyed to a heating and pressurizing device, and a front film layer is applied on the cell string column.

The front film layer may be applied by using a front film layer laying device, which is configured to pull the front film layer to an upper side of the cell string column and cover the front film layer on a front side of the cell string column.

It should be noted that the number of front film layers may be determined based on actual situations and is not limited in this embodiment.

In an embodiment, there may be a single front film layer, which covers all zero-busbar photovoltaic cells in the cell string column. The front film layer is arranged in an elongated strip shape along an extension direction of the cell string column. In other words, only one film layer is provided on the front side of the cell string column. The size of the film layer is not necessarily larger than that of the cell string column. Instead, the size of the front film layer is slightly smaller than that of the cell string column. Each side edge of the cell string column slightly extends beyond the front film layer, and a leading edge and/or a trailing edge of the zero-busbar photovoltaic cells at both ends of the cell string column also extend beyond the front film layer.

In another embodiment, at least two front film layers are applied on the cell string column. Each front film layer covers at least two zero-busbar photovoltaic cells in the cell string column, and the front film layer is arranged in an elongated strip shape along the extension direction of the cell string column. In this case, it is possible to enhance both the laying speed and precision of the front film layer.

It should also be noted that the number of back film layers may vary depending on actual situations and is not limited in this embodiment. The number of back film layers may be one, two, or more.

In an embodiment, synchronously conveying the cell string column and the back film layer to the heating and pressurizing device includes: synchronously conveying the cell string column and a single back film layer to the heating and pressurizing device, such that the back film layer covers all the zero-busbar photovoltaic cells in the cell string column and is arranged in an elongated strip along an extension direction of the cell string column.

In this embodiment, only one film layer is applied on a back side of the cell string column. The size of the back film layer is not necessarily larger than that of the cell string column; rather, the size of the back film layer is slightly smaller than that of the cell string column. Specifically, each side edge of the cell string column slightly extends beyond the back film layer, and a leading edge and/or a trailing edge of the zero-busbar photovoltaic cells at both ends of the cell string column also extend beyond the back film layer.

The conveying of the cell string column is not completely driven by the back film layer. An area of the zero-busbar photovoltaic cell that is not covered by the film layer can be directly sucked through a vacuum suction hole.

In relevant technologies, each cell is covered with a film separately, and each of front and back film layers on each cell has both ends. The front film layer and the back film layer are prone to separating from the cell at these ends, resulting in a relatively high likelihood of separation between the front or back film layer and the cell in a cell string. When the front and back sides of a cell string each are applied with one film layer, the film layer has only two ends in the lengthwise direction of the cell string. This significantly reduces the likelihood of separation between the film layer and the zero-busbar photovoltaic cell, as compared with the relevant technologies.

In another embodiment, synchronously conveying the cell string column and the back film layer to the heating and pressurizing device includes:
conveying the cell string column and at least two back film layers to the heating and pressurizing device, such that each back film layer covers at least two zero-busbar photovoltaic cells in the cell string column and is arranged in an elongated strip along the extension direction of the cell string column. The at least two back film layers are conveyed in sequence. The conveying of the cell string column starts upon the initiation of the conveying of a first back film layer, and ends when the conveying of a last back film layer is finished.

For instance, when there are two back film layers, a first back film layer is conveyed first, followed by a second back film layer. A leading end of the first back film layer in a transport direction is conveyed towards the heating and pressurizing device synchronously with a leading end of the cell string column in the transport direction. After the first back film layer has been conveyed in place, the second layer is then conveyed, and a trailing end of the second back film layer in the transport direction arrives at the heating and pressurizing device synchronously with a trailing end of the cell string column in the transport direction.

When there are more than two front film layers and more than two back film layers, it is optimal to stagger segmented positions between adjacent front film layers and segmented positions between adjacent back film layers to enhance the stability of the cell string.

In the step S103, the heating and pressurizing device is controlled to move to until it comes into contact with the front film layer on the cell string column and to heat and pressurize the front film layer to obtain a cell string.

When the cell string column is conveyed to the heating and pressurizing device, there is no pressing tool on the cell string column. The heating and pressurizing device is in direct contact with the front film layer to heat and pressurize it. Heating is applied to the front film layer from the front side to avoid uneven heating, thereby preventing bubbling and poor soldering. Pressurization on the front side reduces issues such as poor soldering, finger breakage, and bubbling on the front side, while also exerting pressure between the back film layer and the zero-busbar photovoltaic cell.

A back side of the cell string column is heated by a second heating baseplate.

In order to improve the efficiency of string soldering, in an embodiment, controlling the heating and pressurizing device to heat and pressurize the front film layer includes:
controlling the heating and pressurizing device to simultaneously heat and pressurize at least two adjacent zero-busbar photovoltaic cells in the cell string column.

In the string soldering method in this embodiment, the solder strip is pre-fixed to the zero-busbar photovoltaic cell, and then the cell string column formed by pre-fixing is applied with a front film and a back film. Subsequently, the front film layer is heated and pressurized to obtain a cell string. Since the pre-fixing has been carried out before the front film layer is heated and pressurized, there is no need to place a pressing tool on the front side during heating and pressurization. This avoids the phenomenon of uneven heating, thereby preventing issues such as bubbling of the film layer and poor soldering. Meanwhile, heating and pressurization may ensure quality of soldering between the solder strip and the zero-busbar photovoltaic cell, reducing the occurrence of poor soldering and finger breakage. Moreover, by applying pressure on the front side, the front film layer may be prevented from bubbling. In addition, after pre-soldering, the front film layer is heated and pressurized by the heating and pressurizing device, which may prevent the solder strip from shifting. Moreover, in the present application, the solder strips are soldered to the fingers before laying the front film layer and the back film layer, which can address the aforementioned issue of the inability to perform pre-electroluminescence testing for detecting the poor soldering.

Based on the above embodiments, in one embodiment of the present application, when the number of zero-busbar photovoltaic cells in a cell string column is greater than the number of cells required in the cell string, before synchronously conveying the cell string column and the back film layer to the heating and pressurizing device, the cell string soldering method may further include:
controlling a string-cutting device to cut the solder strip on the cell string column to obtain a cell string column of a target length.

In the transportation direction of the cell string column, the string-cutting device is located between the pre-soldering device and the heating and pressurizing device. It is configured to cut the solder strip between the zero-busbar photovoltaic cells to obtain a cell string of the required length.

In this embodiment, by providing the string-cutting device for cutting, the cell string column can be automatically cut with high speed and efficiency, thus saving labor costs.

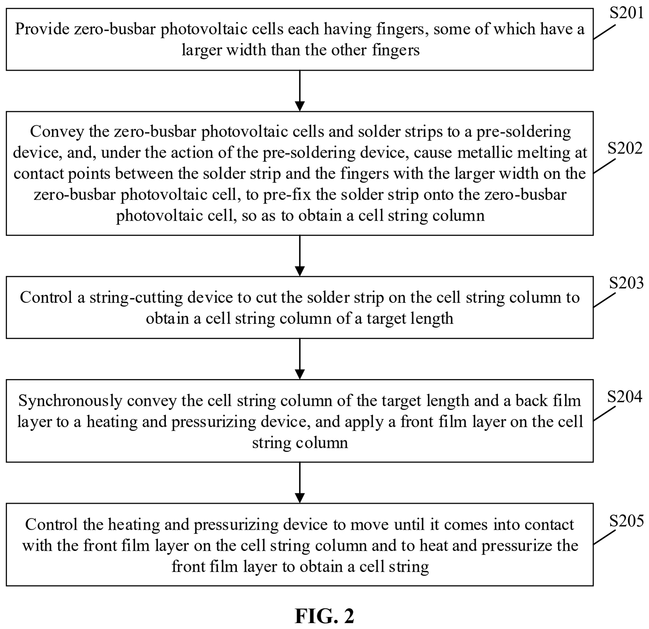

Referring to FIG. 2, based on any of the above embodiments, in an embodiment of the present application, a zero-busbar photovoltaic cell string soldering method may include the following steps.

In a step S201, zero-busbar photovoltaic cells are provided, each having fingers, some of which have a larger width than the other fingers.

It should be noted that, in this embodiment, positions of the wider fingers on the zero-busbar photovoltaic cell are not limited and can be set as desired.

For example, the wider fingers may be located at the edges of the zero-busbar photovoltaic cell, which are located at both ends of the zero-busbar photovoltaic cell in the extension direction of the cell string column. Alternatively, the wider fingers may be located in a middle area between the edges.

It should also be noted that in the present embodiment, the number of wider fingers is not limited herein and can be set as desired. For example, there may be two, three, four, five, six, or more such wider fingers.

In a step S202, the zero-busbar photovoltaic cells and solder strips are conveyed to a pre-soldering device, and, under the action of the pre-soldering device, metallic melting is caused at contact points between the solder strip and the fingers with the larger width on the zero-busbar photovoltaic cell, to pre-fix the solder strip is pre-fixed onto the zero-busbar photovoltaic cell, so as to obtain a cell string column.

By pre-fixing the solder strip to the fingers with the larger width, the difficulty of pre-fixing may be reduced, while enhancing the security of the pre-fixing.

In a step S203, a string-cutting device is controlled to cut the solder strip on the cell string column to obtain a cell string column of a target length.

In a step S204, the cell string column of the target length and a back film layer are synchronously conveyed to a heating and pressurizing device, and a front film layer is applied on the cell string column.

In a step S205, the heating and pressurizing device is controlled to move until it comes into contact with the front film layer on the cell string column and to heat and pressurize the front film layer to obtain a cell string.

Based on the above embodiment, in an embodiment of the present application, the zero-busbar photovoltaic cell string soldering method may further include: widening fingers located at edges of both ends of the zero-busbar photovoltaic cell in the extension direction of the cell string column, such that at least two fingers with the larger width are provided at each edge of the zero-busbar photovoltaic cell.

At least two fingers with the larger width are provided at each side edge of the zero-busbar photovoltaic cell, which may enhance the pre-fixing stability of the solder strip at each side edge.

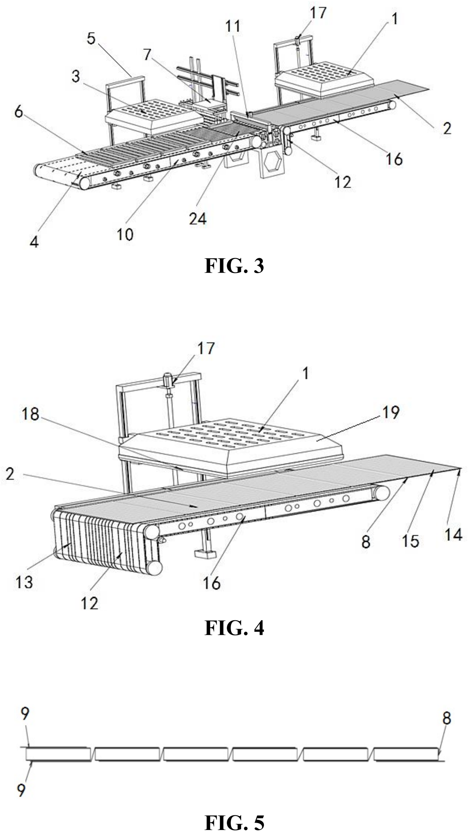

A zero-busbar photovoltaic cell string soldering apparatus is further provided according to the present application. Referring to FIGS. 3 and 4, the zero-busbar photovoltaic cell string soldering apparatus includes: a pre-soldering device, a heating and pressurizing device 1 and a conveying device.

In a transport direction of the cell string, the pre-soldering device is located upstream of the heating and pressurizing device 1, and the conveying device is located downstream of the pre-soldering device.

The pre-soldering device is configured to pre-fix each solder strip onto a surface of the corresponding zero-busbar photovoltaic cell to obtain a cell string column.

The heating and pressurizing device 1 is configured to heat and pressurize a front film layer 15 on the cell string column.

Based on the above embodiments, in one embodiment of the present application, the conveying device is configured to synchronously convey a back film layer 14 and the cell string column to the heating and pressurizing device 1.

The pre-soldering device includes a heating part 3, which is configured to heat to cause the solder strip to be bonded to the fingers on the zero-busbar photovoltaic cell, thereby achieving pre-soldering for fixation.

The pre-soldering device further includes a first conveyor belt 4, a support rod 5, and a pressing tool 6. The first conveyor belt 4 is configured to transport the zero-busbar photovoltaic cell 8 to a position below the heating part 3. The support rod 5 is configured to fix the heating part 3, and a position adjustment component is provided on the support rod 5. By adjusting the position adjustment component, the position of the heating part 3 on the support rod 5 may be changed to adjust the height of the heating part 3 relative to the zero-busbar photovoltaic cell 8. The pressing tool 6 is configured to fix the solder strip 9 on the zero-busbar photovoltaic cell 8.

During the pre-soldering process, the pressing tool 6 is placed on the zero-busbar photovoltaic cell 8. Before the heating and pressurizing device 1 is activated, the pressing tool 6 needs to be removed from the zero-busbar photovoltaic cell 8. In the present application, the manner of removing the pressing tool 6 is not limited herein and can be selected as desired.

In one embodiment, the pressing tool 6 may be removed manually.

In another embodiment, the zero-busbar photovoltaic cell string soldering apparatus may further include a pressing-tool picking device 7.

The pressing-tool picking device 7 is configured to remove the pressing tool located on the cell string column after completion of the pre-soldering.

In the transport direction of the cell string, the pressing-tool picking device is located between the pre-soldering device and the heating and pressurizing device 1.

When the pressing-tool picking device 7 is provided, the pressing tool 6 is automatically picked up from the zero-busbar photovoltaic cell 8, saving manpower and achieving high efficiency.

A front side of one of every two adjacent zero-busbar photovoltaic cells 8 is connected to a back side of the other zero-busbar photovoltaic cell 8 via the solder strip 9, thereby obtaining a cell string column 24, as shown in FIG. 5.

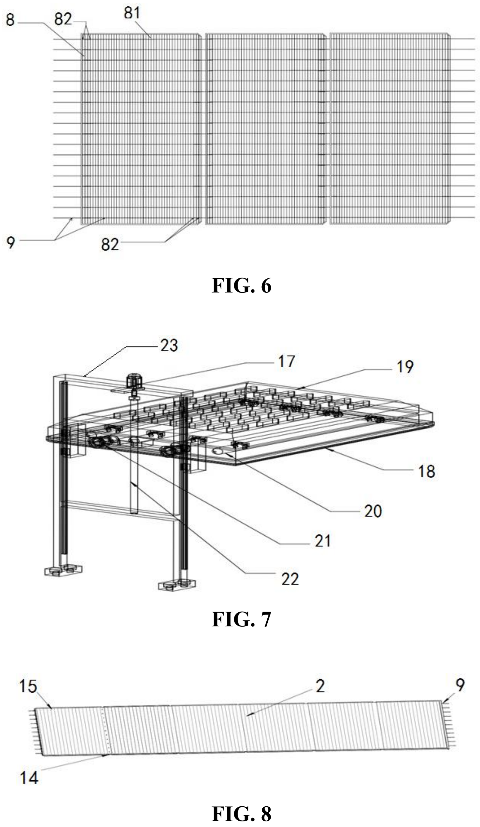

FIG. 6 shows a structural schematic view of the cell string column 24 formed by the zero-busbar photovoltaic cells 8. Fingers 81 are distributed on each zero-busbar photovoltaic cell 8. The pre-soldering device is configured to electrically connect the solder strip 9 to the finger 81 at the edge of each zero-busbar photovoltaic cell 8. During pre-soldering, the number of fingers 81 at each end of the zero-busbar photovoltaic cell 8 that is soldered to the solder strip 9 may range from one to three. To enhance soldering reliability, the finger 81 includes a widened finger 82 to be pre-soldered to the solder strip 9 at each end of the zero-busbar photovoltaic cell 8.

The widened finger 82 may be configured to widen the entire width of the whole finger 81. Alternatively, the widened finger 82 may be configured to locally widen the width in an area of the finger 81 where the solder strip 9 is bonded. This is not limited in the present application. The widening dimension may be set as required and is not limited in the present application.

The zero-busbar photovoltaic cell string soldering apparatus further includes a second conveyor belt 12 and a second heating baseplate 16. The second conveyor belt 12 is configured to convey the pre-soldered cell string column 24 to a position below the heating and pressurizing device 1. The second heating baseplate 16 is located beneath the second conveyor belt 12 and is configured to heat the back side of the cell string column 24. A conveying direction of the second conveyor belt 12 is the same as that of the first conveyor belt 4.

It should be noted that the structure of the heating and pressurizing device 1 is not limited in the present application, as long as it is capable of heating and pressurizing the front film layer 15 on the zero-busbar photovoltaic cell 8.

In an embodiment, the heating and pressurizing device 1 includes a box 19 with an opening, an elastomer 18, and a heating and pressurizing part. The heating and pressurizing part is configured to heat the elastomer 18 and apply pressure to the elastomer 18. The elastomer 18 is located at the opening of the box 19 and forms a seal with the box 19, and the elastomer 18 is configured to make contact with the front side of the cell string column 24.

The elastomer 18 attains a predefined temperature and pressure under the action of the heating and pressurizing part. When contact with the front film layer 15, the elastomer may apply pressure to the front film layer 15, such that the front film layer 15 is tightly and comprehensively adhered to the solder strip 9 and the surface of the zero-busbar photovoltaic cell 8. The solder strip 9 is positioned at a different height from the zero-busbar photovoltaic cell 8. Due to the elasticity of the elastomer, it can ensure that the front film layer 15 is tightly adhered to both the solder strip 9 and the zero-busbar photovoltaic cell 8. Meanwhile, the elastomer transfers heat to the solder strip 9, such that the solder strip 9 is melted and thus bonded more effectively to the fingers 81 on the zero-busbar photovoltaic cell 8, thereby avoiding the occurrence of poor soldering.

The elastomer 18 may be made of materials including, but not limited to, silicone or rubber.

It should also be noted that the heating and pressurizing part is not limited in the present application, and it may be configured based on actual conditions.

In one possible embodiment of the present application, the heating and pressurizing part includes a liquid thermal conductive medium, and the box 19 is provided with a liquid inlet.

The liquid thermal conductive medium is heated to a predefined temperature and then filled into the box 19 through the liquid inlet to come into contact with the elastomer. On one hand, heat may be transferred to the elastomer from the liquid thermal conductive medium, and on the other hand, the liquid thermal conductive medium may apply pressure to the elastomer due to its own weight.

The liquid thermal conductive medium may be thermal conductive oil or the like.

In another possible embodiment of the present application, as shown in FIG. 7, the heating and pressurizing part includes heating bodies 20 and an inflation device. The heating bodies 20 are located inside the box 19. The box 19 is provided with a gas inlet 21, and the inflation device is connected to the gas inlet 21 to introduce gas into the box 19.

The heating bodies 20 are configured to heat an inner layer of the elastomer 18, thereby increasing the temperature of the elastomer 18. The heating bodies 20 may be arranged on an upper wall inside the box 19, facing the elastomer 18.

When an inflation valve located in the inflation device is opened, the gas is introduced into the box 19 from the inflation device through the gas inlet 21. The gas, which may be compressed air, increases the pressure inside the box 19, thereby exerting pressure to the elastomer 18. When the pressure inside the box 19 reaches a predetermined value (for example, 0.3MPa), the inflation valve is closed and the pressure is maintained.

The heating body 20 includes, but is not limited to, at least one of an infrared heating lamp tube, a resistance wire heating tube, a mica radiation heating plate or an array laser heater.

The heating bodies 20 may be uniformly distributed within the box 19, enabling uniform heating of all portions of an inner surface of the elastomer 18, so that the temperature of the elastomer 18 is uniform.

In a possible embodiment, the photovoltaic cell string soldering apparatus may further include: a bracket 23, a driving component 17 and a lifting lead screw 22. The lifting lead screw 22 is connected to both the heating and pressurizing device 1 and the driving component 17. The bracket 23 is configured to fix the box 19. The driving component 17 is configured to drive the lifting lead screw 22 to raise and lower the heating and pressurizing device 1.

The driving component 17 may be a servo motor.

When the front film layer 15 on the cell string column 24 is heated and pressurized by the heating and pressurizing device 1, the elastomer 18 needs to be in contact with a surface of the front film layer 15. When the heating and pressurizing process is completed, the elastomer 18 needs to be separated from the front film layer 15. In this embodiment, the lifting lead screw 22 is driven by the driving component 17 to move the box 19 up and down, thereby adjusting the contact between the elastomer 18 and the front film layer 15. In this embodiment, the contact and separation between the elastomer 18 and the front film layer 15 may be automatically adjusted, which is very convenient and quick.

The conveying device may be a vacuum suction hole 13 formed in the second conveyor belt 12. The second conveyor belt 12 is used to suck the back film layer 14 from its lower side via the vacuum suction hole 13, conveying one end of the back film layer 14 to an end position of the zero-busbar photovoltaic cell 8, and synchronously conveying the back film layer 14 and the cell string column 24 to a position below the heating and pressurizing device 1 such that the back film layer 14 is applied onto the back side of the cell string column 24.

The back film layer 14 and the cell string column 24 are synchronously conveyed by the second conveyor belt 12 to the position below the heating and pressurizing device 1, thereby completing the laying of the back film layer 14. There is no need for a separate step to lay the back film layer 14, saving process time and enhancing the production capacity of the string soldering apparatus.

In the string soldering apparatus according to this embodiment, the zero-busbar photovoltaic cells are first pre-fixed to the solder strips, and then the cell string column formed by pre-fixing is applied with the front and back film layers. Subsequently, the front film layer 15 is heated and pressurized, forming a cell string. Since the pre-fixing has been carried out before the front film layer 15 is heated and pressurized, there is no need to place a pressing tool on the front side during heating and pressurization. This avoids the phenomenon of uneven heating, thereby preventing issues such as bubbling of the film layer and poor soldering. Meanwhile, heating and pressurization process may ensure the quality of soldering between the solder strip and the zero-busbar photovoltaic cell, reducing the occurrence of poor soldering and finger breakage. Moreover, by applying pressure on the front side, the front film layer 15 may be prevented from bubbling. In addition, after pre-soldering, the front film layer 15 is heated and pressurized by the heating and pressurizing device 1, preventing the solder strip from shifting. Moreover, in the present application, the solder strips are soldered to the fingers before laying the front film layer 15 and the back film layer 14, which can address the aforementioned issue of the inability to perform the pre-electroluminescence testing for detecting the poor soldering.

In an embodiment, a single front film layer 15 and a single back film layer 14 may be applied onto one cell string 2, that is, the cell string 2 adopts integral film coverage. As shown in FIG. 8, one front film layer 15 is applied on the front side of the cell string, and one back film layer 14 is applied on the back side of the cell string. In this case, when the second conveyor belt 12 transports the back film layer 14, one end of the back film layer 14 is transported to a head of the cell string 2, such that the back film layer 14 is applied onto the back side of the cell string 2 at one time.

The head of the cell string 2 refers to an end of the cell string column 24 that first reaches the second conveyor belt 12 in the transport direction.

In another possible embodiment, two or three film layers may be applied on each of the front and back sides of the cell string 2.

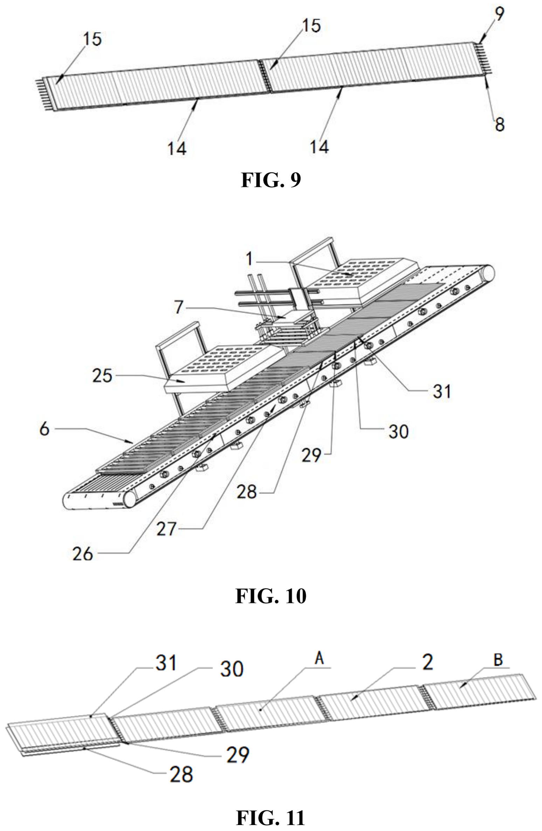

When each of the front and back sides of the cell string column 24 is applied with two film layers, as shown in FIG. 9, there are two front film layers 15 applied on the front side of the cell string column, and there are two back film layers 14 applied on the back side of cell string column.

Based on the above embodiment, in one embodiment of the present application, as shown in FIG. 3, the pre-soldering device may further include a first heating baseplate 10.

The first heating baseplate 10 is located beneath the first conveyor belt 4 and is configured to heat and maintain the temperature of the zero-busbar photovoltaic cell 8 during the pre-soldering process for the cell string column 24.

The first heating baseplate 10 is arranged to assist in heating and temperature-maintaining during the pre-soldering of the solder strips 9 to the finger 81 at the end of the zero-busbar photovoltaic cell 8. This enhances the pre-soldering speed and accelerates the string soldering efficiency.

Based on the above embodiments, in one embodiment of the present application, the zero-busbar photovoltaic cell string soldering apparatus may further include a string-cutting device 11.

The string-cutting device 11 is configured to cut the solder strip 9 to obtain a cell string 2 of a target length.

In the transport direction of the cell string column 24, the string-cutting device 11 is located between the pre-soldering device and the heating and pressurizing device 1.

The string-cutting device 11 includes a cutting tool. Referring to FIG. 3, the string-cutting device 11 is arranged between the pre-soldering device and the heating and pressurizing device 1 and configured to cut the solder strip 9 between the zero-busbar photovoltaic cells 8 to obtain a cell string 2 of the required length.

In this embodiment, the cell string column 24 may be automatically cut by the string-cutting device 11 with high speed and efficiency, thus saving labor costs.

Based on any of the above embodiments, in one embodiment of the present application, the zero-busbar photovoltaic cell string soldering apparatus may further include a front film layer laying device.

The front film layer laying device is configured to draw the front film layer 15 to an upper side of the cell string column 24 and cover the front film layer 15 on the front side of the cell string column 24.

The front film layer 15 is automatically applied by the front film layer laying device, so that it is simple to operate, labor costs are saved, and the string soldering efficiency is improved.

A photovoltaic cell string soldering apparatus is further provided according to the present application. Referring to FIGS. 7, 10 to 11, the photovoltaic cell string soldering apparatus includes a heating device 25, and a heating and pressurizing device 1. The heating device 25 is configured to preheat a front side of the cell string 2. The heating and pressurizing device 1 is configured to pressurize and heat the front side of the cell string 2.

The heating and pressurizing device 1 is located downstream of the heating device 25 in the transport direction of the cell string 2.

The heating and pressurizing device 1 includes a box 19 with an opening, an elastomer 18, and a heating and pressurizing part. The heating and pressurizing part is configured to heat the elastomer 18 and apply pressure to the elastomer 18. The elastomer 18 is located at the opening of the box 19 and forms a seal with the box 19, and the elastomer 18 is configured to make contact with the front side of the cell string 2.

It should be noted that the photovoltaic cell string soldering apparatus further includes a conveyor belt 26, heating baseplates 27 and a pressing tool 6. The heating device 25 and the heating and pressurizing device 1 are both located above the conveyor belt 26. The heating baseplates 27 are located beneath the conveyor belt 26, and are configured to heat a back side of the cell string 2. The pressing tool 6 is configured to be placed on the front side of the cell string 2.

The heating device 25 may be configured as any one of an infrared heating lamp tube, a resistance wire heating tube, a mica radiation heating plate or an array laser heater, which is not limited in the present application. When the cell string 2 is heated by the heating device 25, there is a distance between the heating device 25 and the upper surface of the cell string 2, thereby performing non-contact heating. In contrast, the heating and pressurizing part provides contact heating for the cell string 2.

The heating baseplates 27 are in a continuous heating state, and can be set to different heating temperatures based on process requirements.

FIG. 11 is a schematic view of a cell string 2. The cell string 2 includes a first carrier film 28, a low-temperature solder strip 29, a cell 30, a low-temperature solder strip 29, and a second carrier film 31 stacked in sequence from bottom to top. The first carrier film 28 is located on the back side of the cell 30, and the second carrier film 31 is located on the front side of the cell 30. The state of the cell string 2 before being pressurized and heated by the heating and pressurizing device 1 is shown in an area A of FIG. 11, whereas the state of the cell string 2 after being pressurized and heated by the heating and pressurizing device 1 is shown in an area B of FIG. 11.

The cell string 2 is placed on the conveyor belt 26, with the first carrier film 28 on the back side of the cell string 2 being in contact with the conveyor belt 26 and the heating baseplate 27. Due to the pressure exerted by the weight of the pressing tool 6, the first carrier film 28 is closely adhered to the conveyor belt 26 and the heating baseplate 27. Additionally, the low-temperature solder strip 29 has been preliminarily fused to the cell 30, ensuring effective bonding between the low-temperature solder strip 29 on the back side and the cell 30.

The transport direction of the cell string 2 is the same as a conveying direction of the conveyor belt 26. After the cell string 2 passes through the heating device 25 and before it reaches the heating and pressurizing device 1, the pressing tool 6 needs to be removed from the cell string 2.

The elastomer 18 attains a predefined temperature and pressure under the action of the heating and pressurizing part. When contact with the second carrier film 31 on the front side of the cell string 2, the elastomer 18 may apply pressure to the second carrier film 31, such that the second carrier film 31 is tightly and comprehensively adhered to the low-temperature solder strip 29 and the surface of the cell 30. The low-temperature solder strip 29 is positioned at a different height from the cell 30. Due to the elasticity of the elastomer 18, it can ensure that the second carrier film 31 is tightly adhered to both the low-temperature solder strip 29 and the cell 30. Meanwhile, the elastomer 18 transfers heat to the low-temperature solder strip 29, such that the low-temperature solder strip 29 is melted and thus bonded more effectively to the fingers 81 on the cell 30, thereby avoiding the occurrence of poor soldering. The temperature of an outer surface of the elastomer 18 may range from 100°C to 120°C, and the pressure applied to the elastomer 18 may be 0.3MPa.

The elastomer 18 may be made of materials including, but not limited to, silicone or rubber.

It should be noted that the heating and pressurizing part is not limited in the present application, and it may be configured based on actual conditions.

In one possible embodiment of the present application, the heating and pressurizing part includes a liquid thermal conductive medium, and the box 19 is provided with a liquid inlet.

The liquid thermal conductive medium is heated to a predefined temperature and then filled into the box 19 through the liquid inlet to come into contact with the elastomer 18. On one hand, heat may be transferred to the elastomer 18 from the liquid thermal conductive medium, and on the other hand, the liquid thermal conductive medium may apply pressure to the elastomer due to its own weight.

The liquid thermal conductive medium may be thermal conductive oil or the like.

In another possible embodiment of the present application, as shown in FIG. 7, the heating and pressurizing part includes heating bodies 20 and an inflation device. The heating bodies 20 are located inside the box 19. The box 19 is provided with a gas inlet 21, and the inflation device is connected to the gas inlet 21 to introduce gas into the box 19.

The heating bodies 20 are configured to heat an inner layer of the elastomer 18, thereby increasing the temperature of the elastomer 18. The heating bodies 20 may be arranged on an upper wall inside the box 19, facing the elastomer 18.

When an inflation valve located in the inflation device is opened, the gas is introduced into the box 19 from the inflation device through the gas inlet 21. The gas, which may be compressed air, increases the pressure inside the box 19, thereby exerting pressure to the elastomer 18. When the pressure inside the box 19 reaches a predetermined value (for example, 0.3MPa), the inflation valve is closed and the pressure is maintained.

The heating body 20 includes, but is not limited to, at least one of an infrared heating lamp tube, a resistance wire heating tube, a mica radiation heating plate or an array laser heater.

The heating bodies 20 may be uniformly distributed within the box 19, enabling uniform heating of all portions of an inner surface of the elastomer 18, so that the temperature of the elastomer 18 is uniform.

To better control the pressure applied to the elastomer 18 by the heating and pressurizing part, in one possible embodiment, the photovoltaic cell string soldering apparatus may further include a pressure sensor disposed inside the box 19 for measuring pressure within the box 19. The pressure within the box 19 is equivalent to the pressure applied to the elastomer 18. When the pressure applied to the elastomer 18 reaches a predefined pressure threshold, the pressurization may be stopped.

In order to obtain the temperature of the elastomer 18 in real-time, in one embodiment of the present application, the photovoltaic cell string soldering apparatus may further include a temperature sensor arranged on the outer surface of the elastomer 18 for measuring a temperature of the elastomer 18. When the temperature of the elastomer 18 rises to a predefined temperature threshold, heating of the elastomer 18 may be stopped.

In this embodiment, the heating device 25 and the heating and pressurizing device 1 are provided. The front side of the cell string 2 is preheated by the heating device 25, and then is pressurized and heated by the heating and pressurizing device 1. The elastomer 18 and the box 19 together form a sealed unit, and the elastomer 18 attains a predefined temperature and pressure via the heating and pressurizing part. Pressure is applied by the elastic component to the front side of the cell string 2, preventing the front carrier film from bubbling. Due to the elasticity of the elastic component, the carrier film on the front side of the cell string 2 is tightly adhered to the cell 30, thereby ensuring that the low-temperature solder strip 29 positioned between the front carrier film and the cell 30 is in close contact with the fingers on the cell 30. Meanwhile, the front side of the cell string 2 is heated by the elastic component, causing the low-temperature solder strips 29 to melt. This enhances the quality of soldering between the low-temperature solder strips and the fingers on the cell 30, avoiding issues such as displacement of the low-temperature solder strip 29 caused by lamination during Electroluminescent (EL) test for poor soldering.

Based on the above embodiments, in one possible embodiment, referring to FIG. 7, the photovoltaic cell string soldering apparatus may further include: a bracket 23, a driving component 17 and a lifting lead screw 22. The lifting lead screw 22 is connected to both the heating and pressurizing device 1 and the driving component 17. The bracket 23 is configured to fix the box 19. The driving component 17 is configured to drive the lifting lead screw 22 to raise and lower the heating and pressurizing device 1.

The driving component 17 may be a servo motor.

When the cell string 2 is heated and pressurized by the heating and pressurizing device 1, the elastomer 18 needs to be in contact with the upper surface of the cell string 2. When the heating and pressurizing process is completed, the elastomer 18 needs to be separated from the cell string 2. In this embodiment, the lifting lead screw 22 is driven by the driving component 17 to move the box 19 up and down, thereby adjusting the contact between the elastomer 18 and the surface of the cell string 2. In this embodiment, the contact and separation between the elastomer 18 and the cell string 2 may be automatically adjusted, which is very convenient and quick.

Referring to FIG. 10, based on any of the above embodiments, in one embodiment of the present application, the photovoltaic cell string soldering apparatus may further include a pressing-tool picking device 7. In the transport direction of the cell string 2, the pressing-tool picking device 7 is located between the heating device 25 and the heating and pressurizing device 1.

When the cell string 2 is heated by the heating device 25, the pressing tool 6 is placed on the upper surface of the cell string 2. When the cell string 2 is heated by the heating and pressurizing device 1, the pressing tool 6 is no longer placed on the upper surface of the cell string 2. After the heating device 25 completes heating, the pressing tool 6 placed on the upper surface of the cell string 2 is removed from the cell string 2 by the pressing-tool picking device 7 without manual operation, saving manpower, and offering great convenience.

A string soldering process carried out by the photovoltaic cell string soldering apparatus according to the present application is described below.

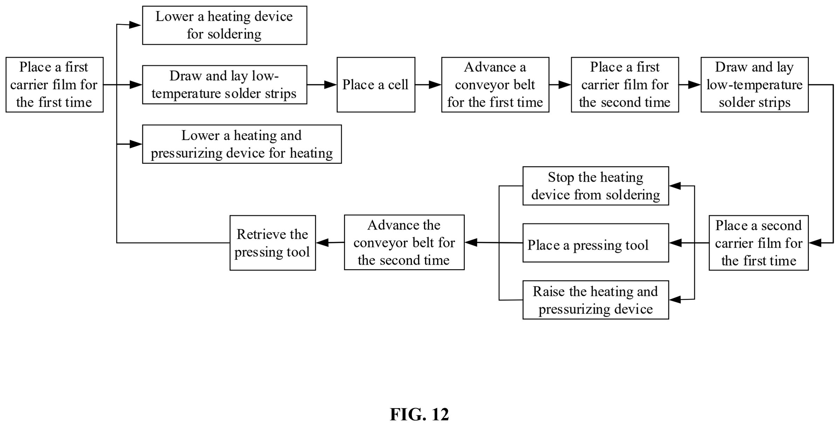

Referring to FIG. 12, after the conveyor belt is advanced for the first time, a first carrier film is placed for the first time, and then low-temperature solder strips are drawn and applied for the first time, followed by the placement of a crystalline silicon cell, a second carrier film and a pressing tool for the first time in turn. After the conveyor belt is advanced for the second (even-numbered) time, the heating device performs non-contact heating on the cell string. The box in the heating and pressurizing device moves downward until it comes into contact with the surface of the second carrier film to apply pressure and heat. The pressing tool placed on the upper surface of the cell string is removed before the heating and pressurizing device applies pressure and heat. The soldering baseplate is in a continuous heating state so as to heat the first carrier film and the low-temperature solder strips on a lower surface of the cell string.

A front side of the cell string is preheated by a heating device, and then is pressurized and heated by the heating and pressurizing device. The elastomer and the box together form a sealed unit, and the elastomer attains a predefined temperature and pressure via the heating and pressurizing part. Pressure is applied by the elastic component to the front side of the cell string, preventing the front carrier film from bubbling. Due to the elasticity of the elastic component, the carrier film on the front side of the cell string is tightly adhered to the cell, thereby ensuring that the low-temperature solder strip positioned between the front carrier film and the cell is in close contact with the fingers on the cell. Meanwhile, the front side of the cell string is heated by the elastic component, such that the low-temperature solder strips is melted. This enhances the quality of soldering between the low-temperature solder strips and the fingers on the cell.

The embodiments in the specification are described in a progressive manner herein, and each of the embodiments is mainly focused on its differences from other embodiments. The same and similar portions among the embodiments can be referred to each other.

A zero-busbar photovoltaic cell string soldering method and a zero-busbar photovoltaic cell string soldering apparatus provided by the present application are described in detail above. Specific embodiments are used herein to explain the principles and implementation of the present application. The above embodiments are illustrated to facilitate understanding the solutions and core concepts of the present application. It should be noted that, for those skilled in the art, various improvements and modifications can be made to the present application without departing from the principles of the present application. These improvements and modifications shall fall within the protection scope of the present application.

## Claims

1. A zero-busbar photovoltaic cell string soldering method, comprising:
conveying zero-busbar photovoltaic cells and solder strips to a pre-soldering device, and performing heating to pre-fix each solder strip onto a surface of the corresponding zero-busbar photovoltaic cell, so as to obtain a cell string column; and
conveying the cell string column to a position below a heating and pressurizing device, controlling the heating and pressurizing device to move until it comes into contact with a front film layer on the cell string column and to heat and pressurize the front film layer, so as to obtain a cell string.

2. The zero-busbar photovoltaic cell string soldering method according to claim 1, wherein pre-fixing each solder strip onto the surface of the corresponding zero-busbar photovoltaic cell comprises:
conveying the zero-busbar photovoltaic cell to a position below a heating device, and placing a pre-fixing adhesive film on a front side of the zero-busbar photovoltaic cell, such that the pre-fixing adhesive film, under the action of the heating device, pre-fixes the solder strip onto a front surface of the cell, and the pre-fixing adhesive film forms the front film layer on the cell string column; and
wherein heating and pressurizing the front film layer comprises:
smoothing out the pre-fixing adhesive film.

3. The zero-busbar photovoltaic cell string soldering method according to claim 1, wherein the cell string column and a back film layer are synchronously conveyed to the heating and pressurizing device, and the front film layer is applied on the cell string column.

4. The zero-busbar photovoltaic cell string soldering method according to claim 3, wherein controlling the heating and pressurizing device to heat and pressurize the front film layer comprises:
controlling the heating and pressurizing device to simultaneously heat and pressurize at least two adjacent zero-busbar photovoltaic cells in the cell string column.

5. The zero-busbar photovoltaic cell string soldering method according to claim 3, wherein there are at least two front film layers applied on the cell string column.

6. The zero-busbar photovoltaic cell string soldering method according to claim 3, wherein synchronously conveying the cell string column and the back film layer to the heating and pressurizing device comprises:
synchronously conveying the cell string column and a single back film layer to the heating and pressurizing device, such that the back film layer covers all the zero-busbar photovoltaic cells in the cell string column and is arranged in an elongated strip along an extension direction of the cell string column.

7. The zero-busbar photovoltaic cell string soldering method according to claim 3, wherein synchronously conveying the cell string column and the back film layer to the heating and pressurizing device comprises:
conveying the cell string column and at least two back film layers to the heating and pressurizing device, such that each back film layer covers at least two zero-busbar photovoltaic cells in the cell string column and is arranged in an elongated strip along an extension direction of the cell string column, wherein the at least two back film layers are conveyed in sequence, the conveying of the cell string column starts upon initiation of the conveying of a first back film layer, and ends when the conveying of a last back film layer is finished.

8. The zero-busbar photovoltaic cell string soldering method according to claim 3, wherein before synchronously conveying the cell string column and the back film layer to the heating and pressurizing device, the zero-busbar photovoltaic cell string soldering method further comprises:
controlling a string-cutting device to cut the solder strip on the cell string column to obtain a cell string column of a target length.

9. The zero-busbar photovoltaic cell string soldering method according to claim 3, further comprising providing the zero-busbar photovoltaic cells each having fingers, some of which have a larger width than the other fingers;
wherein performing heating to pre-fix each solder strip onto the surface of the corresponding zero-busbar photovoltaic cell comprises:
under the action of the pre-soldering device, causing metallic melting of the solder strip at contact points with the fingers with the larger width on the zero-busbar photovoltaic cell, to pre-fix the solder strip onto the zero-busbar photovoltaic cell.

10. The zero-busbar photovoltaic cell string soldering method according to claim 9, further comprising:
widening fingers located at edges of both ends of the zero-busbar photovoltaic cell in an extension direction of the cell string column, such that at least two fingers with the larger width are provided at each edge of the zero-busbar photovoltaic cell.

11. A zero-busbar photovoltaic cell string soldering apparatus, comprising:
a pre-soldering device;
a heating and pressurizing device; and
a conveying device,
wherein in a transport direction of a cell string, the pre-soldering device is located upstream of the heating and pressurizing device, and the conveying device is located downstream of the pre-soldering device;
the pre-soldering device is configured to pre-fix each solder strip onto a surface of a corresponding zero-busbar photovoltaic cell to obtain a cell string column; and
the heating and pressurizing device is configured to heat and pressurize a front film layer on the cell string column.

12. The zero-busbar photovoltaic cell string soldering apparatus according to claim 11, wherein the conveying device is configured to synchronously convey a back film layer and the cell string column to the heating and pressurizing device.

13. The zero-busbar photovoltaic cell string soldering apparatus according to claim 12, further comprising:
a pressing-tool picking device, which is configured to remove a pressing tool located on the cell string column after pre-soldering,
wherein the pressing-tool picking device is located between the pre-soldering device and the heating and pressurizing device in the transport direction of the cell string.
